# EUROPEAN PATENT APPLICATION

(11) **EP 0 642 136 A2**
(43) Date of publication of application: **08.03.1995**
(21) Application number: 94114111.1
(22) Date of filing: 08.09.1994
(51) Int. Cl.: G11C 29/00, G06F 12/06

(54) **Apparatus for generating address data**

(30) Priority: 08.09.1993 KR 1802693
(71) Applicant: DAEWOO ELECTRONICS CO., LTD, Jung-Gu, Seoul 100-095 (KR)
(72) Inventor: Kim, Young-Sang, Kangseo-Ku, Seoul (KR)
(74) Representative: von Samson-Himmelstjerna, Friedrich R., Dipl.-Phys.

(57) **Abstract**

An address generator capable of generating address data for sequentially accessing a memory from a selected memory location has a first dip switch for manually setting first reference address data and a second dip switch for manually setting second reference address data, a first counter for loading the first reference address data from the first dip switch, and in synchronization with a first clock pulse, producing lower M-bit address data, a second counter 20 for loading the second reference address data from the second dip switch, and in synchronization with a second clock pulse, producing higher M-bit address data, an AND gate for generating a second clock pulse, and a control unit for generating a first and a second control signals, wherein the first control signal is applied to the first and the second counters and the second control signal is applied to the AND gate.

## Description

### Field of the Invention

The present invention relates to an apparatus for generating address data; and, more particularly, to an apparatus for use in a test pattern generator, which is capable of generating address data for sequentially accessing a memory from an arbitrarily selected memory location.

### Description of the prior Art

Heretofore, various test pattern generators have been used to generate test patterns for diagnosing a semiconductor integrated circuit(IC). A test pattern generator forms a part of an IC tester for testing semiconductor ICs and generates test patterns, each of the test patterns comprising test data to be applied to an IC being tested and a reference value for comparison with the output data from the IC tested.

Typically, the test pattern generator includes a memory for storing a plurality of test patterns and an address generator which generates address data for sequentially accessing the test patterns stored in the memory.

A conventional address generator, however, lacks the ability to generate address data having the flexibility of selectively accessing a certain portion of the test patterns stored in the memory.

### Summery of the Invention

It is, therefore, a primary object of the present invention to provide an apparatus which is capable of generating address data for sequentially accessing a memory from an arbitrarily selected memory location.

In accordance with the present invention, there is provided an apparatus for generating address data to sequentially access a memory from an arbitrarily selected memory location, the address data having lower address and higher address data, which comprises: a first means for manually setting first reference address data; a first counting means for loading the first reference address data as a first initial count in response to a first control signal, incrementing the first initial count by 1 and simultaneously providing the incremented count to the memory as the lower address data, and generating a carry signal when the incremented count reaches a predeterimined value; a second means for manually setting second reference address data; a second counting means for loading the second reference address data as a second initial count in response to the first control signal and incrementing the second initial count by 1 in response to the carry signal and simultaneously providing the incremented count to the memory as the higher address data; a coupling means for, in response to a second control signal, coupling the carry signal to the second counting means; and a control means for generating the first and the second control signals.

### Brief Description of the Drawings

The above and other objects and features of the present invention will become apparent from the following description of preferred embodiments given in conjunction with the accompanying drawings, in which:
Fig. 1 is a schematic diagram illustrating the inventive address generator capable of generating address data for sequentially accessing arbitrarily selected memory locations; and
Fig. 2 provides address data for explaining an exemplary operation of the address generator in accordance with the present invention.

### Detailed Description of the Preferred Embodiments

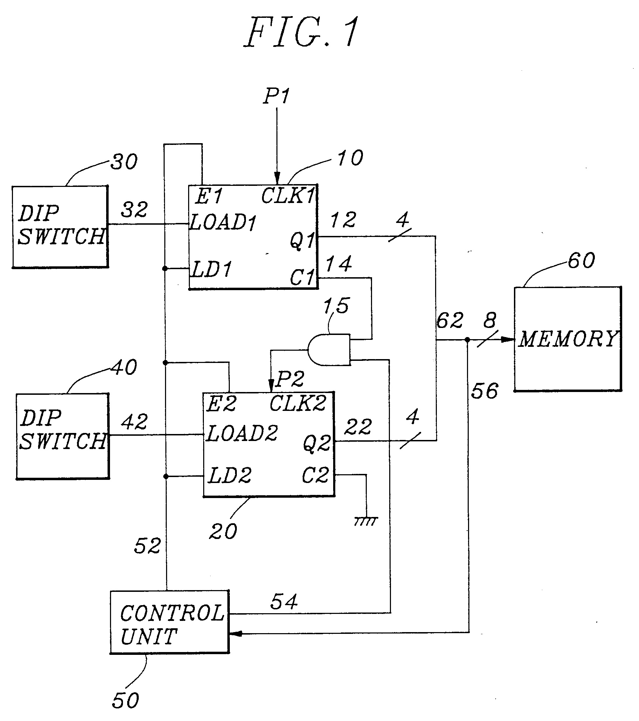

Referring to Fig. 1, there is shown an address generator in accordance with a preferred embodiment of the present invention, which is capable of generating address data for sequentially accessing arbitrarily selected memory locations, wherein the address data has lower address and higher address data.

The address generator comprises a first and a second dip switches 30 and 40, a first and a second counters 10 and 20, and a control unit 50. A preset counter with an initial counting value may be employed as the counters 10 and 20, respectively, as well known in the art. The first counter 10 loads first reference address data from the first dip switch 30 as a first initial counting value and produces a lower M-bit, e.g., 4-bit, address data. The second counter 20 loads second reference address data from the second dip switch 40 as a second initial counting value and produces a higher M-bit, e.g., 4-bit, address data. The lower and higher M-bit address data form 2M-bit address data for accessing a memory 60. The counters 10 and 20 are enabled by the control unit 50. The control unit 50 generates a first and a second control signals, wherein the first control signal is applied to the first and the second counters 10 and 20, and the second control signal is applied to an AND gate 15.

The dip switches 30 and 40 are manually set by a user to generate the first and the second reference address data loaded into the first and the second counters 10 and 20 at the positive edge of the first control signal as the first and the second initial counting values thereof.

Specifically, the first counter 10 is enabled by the first control signal with logic "1" applied to an enable terminal E1 via line 52 from the control unit 50. The enabled first counter 10, in response to the positive edge of the first control signal simultaneously applied to a terminal LD1, loads the M-bit first reference address data fed to a terminal LOAD1 via line 32 from the first dip switch 30 as the first initial counting value thereof, and increments the first initial counting value by 1 and simultaneously outputs at its output terminal Q1 the incremented counting value on line 12 as the lower 4-bit address data, each time clock pulse P1(e.g., rectangular wave with 50 % duty cycle) is applied to a terminal CLK1. Also, the first counter 10 produces at its terminal C1 a carry signal with logic "1" whenever the incremented counting value reaches a predeterimined value(i.e., binary number 1111) and supplies the carry signal via line 14 to a first input of an AND gate 15. A second input of the AND gate 15 is provided with the second control signal through line 54 from the control unit 50. An output of the AND gate 15 is logic "1" when its two inputs are logic "1", respectively; and, otherwise, the output is logic "0". Accordingly, the AND gate 15 outputs logic "1" when the carry signal applied to its first input and the second control signal are logic "1", concurrently.

The second counter 20 is also enabled by the first control signal with logic "1" applied to an enable terminal E2 via line 52 from the control unit 50. The enabled second counter 20 loads the M-bit second reference address data fed to a terminal LOAD2 through line 42 from the second dip switch 40 as a second initial counting value thereof, in response to the positive edge of the first control signal simultaneously applied to a terminal LD2, and increments the second initial counting value by 1 and simultaneously outputs at its output terminal Q2 the incremented counting value on line 22 as the higher 4-bit address data in synchronization with a second clock pulse P2(i.e., the output of the AND gate 15) applied to a terminal CLK2. A terminal C2 of the second counter 20 is grounded.

In accordance with the present invention, the 2M-bit, i.e., 8-bit, address data formed by the lower M-bit address data on line 12 and the higher M-bit address data on line 22, is applied to the memory 60 via line 62 and the control unit 50 via line 56. If the second control signal is logic "0" and the lower 4-bit address data fed to the control unit 50 is a binary number 1111, or the second control signal is logic "1" and both the lower and the higher 4-bit address data applied to the control unit 50 through line 56 are binary number 1111, then the control unit 50 generates the first control signal with logic "0". At this time, the counters 10 and 20 are disabled.

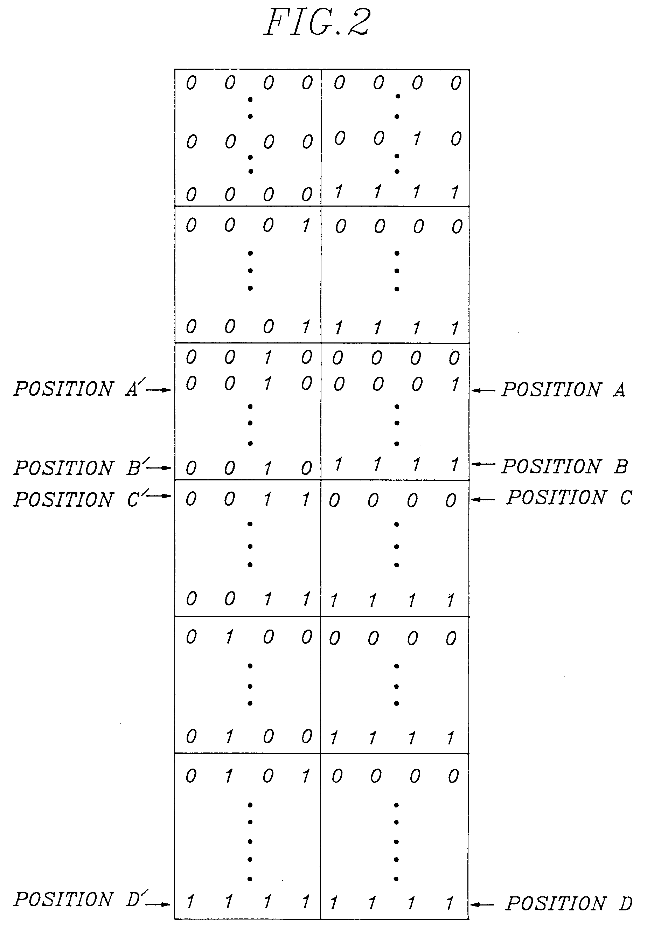

The operation of the address generator in accordance with a preferred embodiment of the present invention will now be described in detail with reference to Fig. 2. By way of illustration, in case the second control signal is logic "0" and the first and the second reference address data are binary numbers 0001 (position A) and 0010 (position A'), then the first counter 10 counts from 0001 to 1111 and sequentially provides the address data(i.e., 0001 - 1111) between the position A and a position B on line 12 as the lower 4-bit address data, and the second counter 20 provides the second reference address data(i.e., 0010) loaded thereto on line 22 as the higher 4-bit address data. Accordingly, 8-bit address data(i.e., 00100001 - 00101111) are sequentially applied to the memory 60, and thus the memory locations corresponding to the 8-bit address data are sequentially scanned. If the second control signal is logic "1" and the first and the second reference address data are binary numbers 0001 and 0010, respectively, then the first counter 10 goes through the following sequence of binary numbers: 0001, 0010, ... 1110, 1111, 0000, 0001, ..., 1110, 1111 (from position A to a position D) and sequentially provides the address data between positions A and D on line 12 as the lower 4-bit address data. The second counter 20 increments the second initial counting value by 1 when the output of the first counter 10 changes from 1111 to 0000. For example, when the output of the first counter 10 changes from 1111(e.g., position B) to 0000(e.g., position C), the second counter 20 changes from 0010(position B') to 0011(position C'). Accordingly, 8-bit address data(i.e., 00100001 - 11111111) are applied to the memory 60, and thus the memory locations corresponding to the 8-bit address data are sequentially scanned.

While the present invention has been shown and described with reference to the particular embodiments, it will be apparent to those skilled in the art that many changes and modifications may be made without departing from the spirit and scope of the invention as defined in the appended claim.

## Claims

1. An apparatus for generating address data to sequentially access a memory from an arbitrarily selected memory location, the address data having lower address and higher address data, which comprises:
a first means for manually setting a first reference address data;
a first counting means for loading the first reference address data as a first initial count in response to a first control signal, incrementing the first initial count by 1 and simultaneously providing the incremented count to the memory as the lower address data, and generating a carry signal when the incremented count reaches a predeterimined value;
a second means for manually setting a second reference address data;
a second counting means for loading the second reference address data as a second initial count in response to the first control signal and incrementing the second initial count by 1 in response to the carry signal and simultaneously providing the incremented count to the memory as the higher address data;
a coupling means for, in response to a second control signal, coupling the carry signal to the second counting means; and
a control means for generating the first and the second control signals.
